# EUROPEAN PATENT SPECIFICATION

(11) **EP 3 149 328 B1**
(45) Date of publication and mention of the grant of the patent: **20.03.2019**
(21) Application number: 15729984.3
(22) Date of filing: 28.05.2015
(51) Int. Cl.: F04B 9/02, F04B 17/03, F04B 19/04, F04B 23/04, F04B 43/02, F04B 49/10, F04B 49/22, F04B 51/00, F04B 53/10, F04B 53/16, F16H 25/20, F04B 13/00, F04B 43/04, F04B 53/20, H01L 21/67

(54) **SYSTEM AND METHOD FOR OPERATION OF A PUMP WITH FEED AND DISPENSE SENSORS, FILTRATION AND DISPENSE CONFIRMATION, AND REDUCED PRESSURE PRIMING OF FILTER**
VORRICHTUNG UND VERFAHREN ZUM BETRIEB EINE PUMPE MIT ZULAUF- UND FÖRDER-SENSOREN, FILTRATION- UND FÖRDER-BESTÄTIGUNG, SOWIE VERRINGERTER FILTERANSAUGDRUCK
SYSTÈME ET PROCÉDÉ POUR OPÉRER UNE POMPE AVEC SENSEURS D'ALIMENTATION ET DE SORTIE, CONFIRMATION DE FILTRATION ET DE POMPAGE, ET PRESSION D'AMORÇAGE DE FILTRATION RÉDUIT

(30) Priority: 28.05.2014 US 201462004117 P
(43) Date of publication of application: 05.04.2017
(73) Proprietor: Entegris, Inc., Billerica, MA 01821-4600 (US)
(72) Inventor: CEDRONE, James, Braintree, MA 02184 (US); GASHGAEE, Iraj, Marlborough, MA 01752 (US); GONNELLA, George, L., Pepperell, MA 01463-0412 (US)
(74) Representative: Greaves Brewster LLP
(86) International application number: PCT/US2015/032817
(87) International publication number: WO 2015/184057

(56) References cited:
- US-A1- 2004 076 526
- US-A1- 2005 184 087
- US-A1- 2007 128 046
- US-A1- 2008 190 176

## Description

### CROSS-REFERENCE TO RELATED APPLICATION(S)

This application claims a benefit of priority from U.S. Provisional Application No. 62/004,117, filed May 28, 2014.

### TECHNICAL FIELD

This disclosure relates generally to fluid pumps. More particularly, embodiments disclosed herein relate to single and multi-stage pumps, including pumps used in semiconductor manufacturing. Even more particularly, embodiments of the invention relate to operating a pump, and/or confirming various operations, or actions, of a pump, including filtration confirmation, dispense confirmation, air detection, and reduced pressure priming of a filter in a pump.

### BACKGROUND

There are many applications for which precise control over the amount and/or rate at which a fluid is dispensed by a pumping apparatus is necessary. In semiconductor processing, for example, it is important to control the amount and rate at which photochemicals, such as photoresist chemicals, are applied to a semiconductor wafer. The coatings applied to semiconductor wafers during processing typically require an even, consistent flatness across the surface of the wafer that is measured in angstroms. The rates at which processing chemicals are applied to the wafer have to be carefully calibrated and precisely controlled to ensure that the processing liquid (i.e., a semiconductor manufacturing process fluid which contains the chemicals) is applied accurately and uniformly.

Many photochemicals used in the semiconductor industry today are very expensive, frequently costing as much as U.S. $1,000 dollars a liter. Therefore, it is preferable to ensure that a minimum but adequate amount of chemicals is used and that the process liquid or fluid containing the chemicals is not damaged by the pumping apparatus. However, various conditions during operation of a pumping apparatus may result in pressure spikes or drops in pressure that can damage a process fluid (i.e., may change the physical characteristics of the process fluid unfavorably), lead to dispensing too much or too little process fluid, or introduce unfavorable dynamics into a dispense operation of a process fluid. Other conditions occurring within a pumping apparatus may also prevent proper dispense of a process fluid. These conditions may result from timing changes in the process itself. When these conditions occur, the result can be an improper dispense of a process fluid onto the wafer, rendering the wafer unsuitable for use and resulting, eventually, in the wafer being discarded as scrap.

Exacerbating this problem is the fact that, in many cases, the scrap wafer is only detected using some form of quality control procedure after the wafer has been further processed. Meanwhile, the condition that resulted in the improper dispense, and hence the scrap wafer, persists. Consequently, in the interim between the first improper dispense and the detection of the scrap wafer, many additional improper deposits may have occurred on other wafers. Unfortunately, these wafers must, in turn, also be discarded as scrap.

As can be seen, then, it is desirable to detect or confirm that a proper dispense has occurred. Such a dispense confirmation has, in the past, been accomplished using a variety of techniques. As an example, a prior dispense confirmation method involves utilizing a camera system at the dispense nozzle of a pump to confirm that a dispense has taken place. This solution is not optimal, however, as these camera systems are usually independent of a pumping system and thus must be separately installed and calibrated to work with a pumping system. Furthermore, in the vast majority of cases, these camera systems tend to be prohibitively expensive.

Another method involves the use of a flow meter in a fluid flow path of a process fluid in a pumping system to confirm that a dispense has taken place. This method can also be problematic. For example, inserting a flow meter as an additional component into the fluid flow path not only raises the cost of the pumping system but also increases the risk of contamination of the process fluid as it flows through the inserted flow meter.

In view of the foregoing, what is needed are methods and systems for confirming operations and actions of a pump which may quickly and accurately detect the proper completion of these operations and actions and which may provide early warnings and/or take appropriate action when needed to ensure efficient operations and quality results. Embodiments disclosed herein can address this need and more.

US2007/0128046A1 discloses a pumping system that accurately dispenses fluid using a multiple stage pump. In an embodiment a pressure sensor at the dispense stage pump determines the pressure in a dispense chamber.

US2008/190176A1 discloses a method and device for monitoring a fluid flow delivered by means of a pump. In the device at least one pressure sensor is provided for the continuous or quasi-continuous measurement of the pressure of a fluid at least in partial areas of the pump stroke.

### SUMMARY

An aspect of the present invention provides a pumping system according to claim 1.

In some embodiments, the pumping system may include a fluid source, and a pump controller communicatively connected to the multiple stage pump via one or more network communications links. The pump controller may also be communicatively connected to a control device such as a pump track, a management station, or the like.

In some embodiments, the feed stage portion may include a bottle or a reservoir tank and a pressure sensor mounted thereon. The pressure sensor can be mounted on a sidewall of the feed chamber, bottle, or reservoir tank to detect fluid pressure therein. In one embodiment, the pressure sensor can be flush mounted to the sidewall. In some embodiments, the pressure sensor can be mounted at an angle on the sidewall. In some embodiments, the angle at which the pressure sensor is mounted on the sidewall can be about 5 to 10 degrees, about 45 degrees, or as steep as possible relative to the sidewall to avoid trapping air. In one embodiment, the pressure sensor is mounted on the sidewall such that the sensing portion of the pressure sensor points upwards. In some embodiments, the pressure sensor can be mounted at or near the half-height of the feed chamber, bottle, or reservoir tank. In some embodiments, the pressure sensor can be mounted at or near the bottom of the feed chamber, bottle, or reservoir tank.

In some embodiments, the fluid pressure as detected by the pressure sensor on the fill side can have many beneficial uses, including a filtration confirmation, an air detection test, and a filter priming routine. In some embodiments, the filtration confirmation may include determining an operating fill pressure profile based at least in part on the fluid pressure as detected by the pressure sensor, comparing the operating fill pressure profile with a reference fill pressure profile, and determining whether to generate an alarm. In some embodiments, the air detection test may include isolating a portion of the multiple stage pump, controlling the feed motor to bring the isolated portion to a first pressure, moving the feed motor a fixed distance, detecting a second pressure using the pressure sensor, and determining a differential pressure indicating a change between the first pressure and the second pressure which correlates to an amount of air in the isolated portion. In some embodiments, the filter priming routine may include determining whether an isolated portion of the multiple stage pump has reached a negative or reduced pressure and soaking the filter in the process fluid at the negative or reduced pressure for a period of time to degas or remove gas or bubbles from the process fluid in the isolated portion of the multiple stage pump.

In some embodiments, the pumping system may further include a graphical user interface for displaying operating profiles for a plurality of pump operation parameters monitored by the pump controller. The graphical user interface may display a plurality of user-selectable alarm types for the operating profiles, including information alarms, warning alarms, error alarms, and critical alarms.

In some embodiments, the operating profiles may include information collected during a dispense cycle including ready, dispense, filtration, vent, purge, air detection, and fill segments. In particular, in some embodiments, the operating profiles may include a pressure profile for the fluid pressure in the feed chamber.

Numerous other embodiments may also be possible.

These, and other, aspects of the invention will be better appreciated and understood when considered in conjunction with the following description and the accompanying drawings. The following description, while indicating various embodiments of the invention and numerous specific details thereof, is given by way of illustration and not of limitation. Many substitutions, modifications, additions or rearrangements may be made within the scope of the invention, as defined by the respective subject-matter of the appended patent claims.

### BRIEF DESCRIPTION OF THE DRAWINGS

The drawings accompanying and forming part of this specification are included to depict certain aspects of the invention. A clearer impression of the invention, and of the components and operation of systems provided with the invention, will become more readily apparent by referring to the exemplary, and therefore non-limiting, embodiments illustrated in the drawings, wherein identical reference numerals designate the same components. Note that the features illustrated in the drawings are not necessarily drawn to scale.
FIGURE 1 depicts a diagrammatic representation of an exemplary pumping system.
FIGURE 2A depicts a diagrammatic representation of an exemplary multiple stage pump ("multi-stage pump") according to one embodiment.
FIGURE 2B depicts a diagrammatic representation of another exemplary multi-stage pump according to one embodiment.
FIGURES 3A and 3B depict valve and motor timing diagrams for an exemplary multi-stage pump.
FIGURE 4 depicts a diagrammatic representation of one embodiment of an interface illustrating operating profiles for various pump operation parameters.
FIGURES 5A and 5B depict diagrammatic representations of one embodiment of an interface illustrating an example set of monitored data.
FIGURE 6 depicts a diagrammatic representation of one embodiment of a graphical user interface illustrating one embodiment of configuring a priming cycle.

### DETAILED DESCRIPTION

Systems and methods and advantageous details thereof are explained more fully with reference to the non-limiting embodiments that are illustrated in the accompanying drawings and detailed in the following description. Descriptions of well-known starting materials, processing techniques, components and equipment are omitted so as not to unnecessarily obscure the invention in detail. It should be understood, however, that the detailed description and the specific examples, while indicating preferred embodiments of the invention, are given by way of illustration only and not by way of limitation. Various substitutions, modifications, additions and/or rearrangements within the scope of the invention, as defined by the respective subject-matter of the appended patent claims, will become apparent to those skilled in the art from this disclosure.

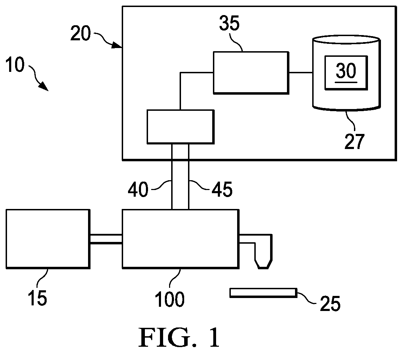

Before describing embodiments, it may be useful to describe an exemplary pump or pumping system which may be utilized with various embodiments. FIGURE 1 depicts a diagrammatic representation of a pumping system 10. Pumping system 10 can include a fluid source 15, a pump controller 20 and a multi-stage pump 100, which work together to dispense fluid onto a wafer 25. Fluid source 15 can be any appropriate source such as a tank, a bottle, a fluid processing system, or a fluid carrying network from which multi-stage pump 100 obtains a process fluid, for instance, a semiconductor manufacturing process fluid. Semiconductor manufacturing processes are known to those skilled in the art and thus are not described herein.

Operation of multi-stage pump 100 can be controlled by pump controller 20, which can be onboard multi-stage pump 100 or connected to multi-stage pump 100 via one or more communications links for communicating control signals, data or other information. Pump controller 20 can include a variety of computer components known in the art, including processors, memories, interfaces, display devices, peripherals, or other computer components. For example, pump controller 20 can include a processor 35 implementing a Central Processing Unit (CPU), Application Specific Integrated Circuit (ASIC), Digital Signal Processing (DSP), Reduced Instruction Set Computing (RISC) or other processor. One example of a suitable processor is the Texas Instruments TMS320F28335PGFA 16-bit DSP (Texas Instruments is a Dallas, TX based company). Additionally, pump controller 20 can include at least one computer readable medium 27 (e.g., random access memory (RAM), read-only memory (ROM), flash memory, optical disk, magnetic drive or other computer readable medium).

In the example of FIGURE 1, pump controller 20 communicates with multi-stage pump 100 via communications links 40 and 45. Communications links 40 and 45 can be networks (e.g., Ethernet, EtherCAT, wireless network, global area network, DeviceNet network or other network known or developed in the art), a bus (e.g., Small Computer System Interface (SCSI) bus) or other communications links. These communications components are known to those skilled in the art.

Pump controller 20 can be implemented as an onboard printed circuit board (PCB), remote controller, or in other suitable manner. Pump controller 20 can include appropriate interfaces (e.g., EtherCAT, network interfaces, input/output (I/O) interfaces, analog to digital converters and other components) to allow pump controller 20 to communicate with multi-stage pump 100, pump tracks, management stations, etc.

A pump track refers to a tool or system with necessary hardware and software to perform an operation (e.g., a chemical deposition or fluid coating process) on a wafer surface. In doing so, a precise volume of fluid needs to be applied to the surface of wafer 25. Pump controller 20 can control various valves and motors in multi-stage pump 100 to cause multi-stage pump 100 to accurately dispense various types of fluids, including low viscosity fluids (i.e., less than 5 centipoise). The control logic for controlling the operation of multi-stage pump 100 may be embodied on pump controller 20, a management station, and/or other computing device. In pump controller 20, control instructions 30 may be embodied on non-transitory computer readable medium 27. Examples of control schemes can be found in U.S. Patent No. 8,029,247, entitled "SYSTEM AND METHOD FOR PRESSURE COMPENSATION IN A PUMP"; U.S. Patent No. 7,443,483, entitled "SYSTEMS AND METHODS FOR FLUID FLOW CONTROL IN AN IMMERSION LITHOGRAPHY SYSTEM"; U.S. Patent No. 8,172,546, entitled "SYSTEM AND METHOD FOR CORRECTING FOR PRESSURE VARIATIONS USING A MOTOR"; U.S. Patent No. 7,850,431, entitled "SYSTEM AND METHOD FOR CONTROL OF FLUID PRESSURE"; U.S. Patent No. 7,878,765, entitled "SYSTEM AND METHOD FOR MONITORING OPERATION OF A PUMP"; and U.S. Patent No. 7,940,664, entitled "I/O SYSTEMS, METHODS AND DEVICES FOR INTERFACING A PUMP CONTROLLER".

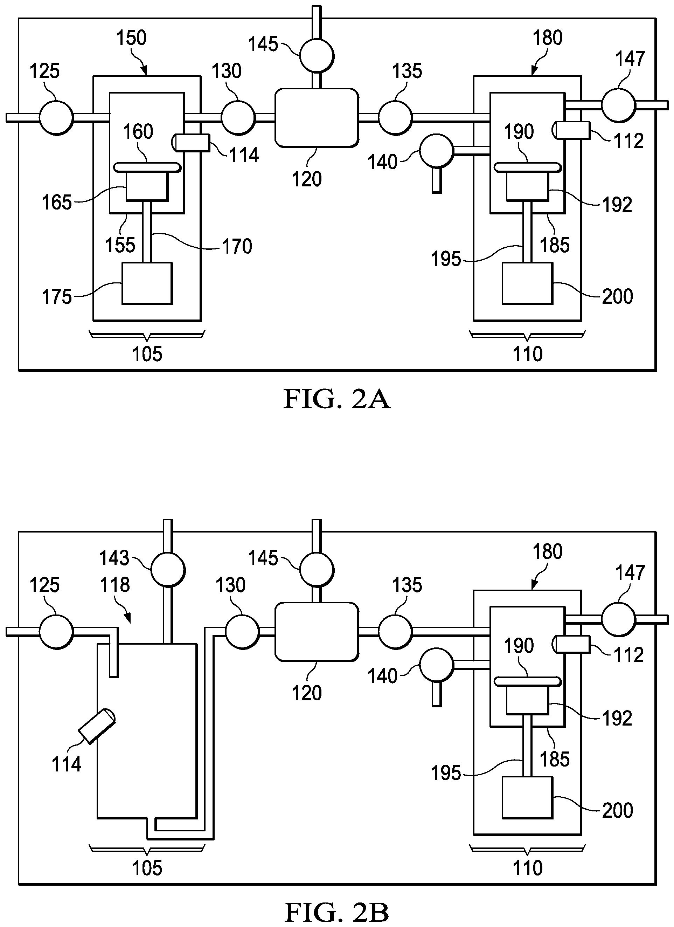

FIGURE 2A depicts a diagrammatic representation of multi-stage pump 100. In this example, multi-stage pump 100 includes a feed stage portion 105 and a separate dispense stage portion 110. Located between feed stage portion 105 and dispense stage portion 110, from a fluid flow perspective, is filter 120 to filter out or otherwise remove impurities from a process fluid.

Feed stage portion 105 and dispense stage portion 110 can include pumps 150, 180 for directing the process fluid to flow from a fluid source (e.g., fluid source 15 shown in FIGURE 1) to feed stage 105 to filter 120 to dispense stage 110 to a point of dispense or use. To control the fluid flow, multi-stage pump 100 includes a number of valves including, for example, inlet valve 125, isolation valve 130, barrier valve 135, purge valve 140, vent valve 145 and outlet valve 147. These valves are opened or closed to allow or restrict fluid flow to various portions of multi-stage pump 100. For example, these valves can be pneumatically actuated (i.e., gas driven) diaphragm valves that open or close depending on whether pressure or a vacuum is asserted. However, any suitable valve can be used.

In the example of FIGURE 2A, feed-stage pump 150 ("feed pump 150") includes a feed chamber 155 to collect fluid, a feed stage diaphragm 160 to move within feed chamber 155 and displace fluid, a piston 165 to move feed stage diaphragm 160, a lead screw or ball screw 170 connected to piston 165, and a feed motor 175 (e.g., a stepper motor) to drive lead screw or ball screw 170 and hence piston 165. As an example, lead screw or ball screw 170 can be coupled to motor 175 through a nut, gear or other mechanism for imparting energy from motor 175 to lead screw or ball screw 170. Specifically, motor 175 is operable to rotate the nut that, in turn, imparts linear motion to lead screw or ball screw 170, causing piston 165 to actuate.

Similarly, in the example of FIGURE 2A, dispense-stage pump 180 ("dispense pump 180") includes a dispense chamber 185, a dispense stage diaphragm 190, a piston 192, a lead screw 195, and a dispense motor 200. Those skilled in the art can appreciate that a variety of pumps may be used in feed stage 105 and dispense stage 110 and that feed pump 150 and dispense pump 180 need not be limited to rolling diaphragm pumps.

Likewise, feed motor 175 and dispense motor 200 can be any suitable motor. As an example, dispense motor 200 can be a Permanent-Magnet Synchronous Motor ("PMSM"). The PMSM can be controlled by a digital signal processor ("DSP") utilizing Field-Oriented Control ("FOC") or other type of speed/position control at dispense motor 200, a controller onboard multi-stage pump 100 or a separate pump controller (e.g., pump controller 20 shown in FIGURE 1). Dispense motor 200 implementing a PMSM can further include an encoder (e.g., a fine line rotary position encoder) for real time feedback of motor position. The use of a position sensor enables accurate and repeatable control of motor position and hence the position of piston 192, which leads to accurate and repeatable control over fluid movements in dispense chamber 185. For, example, using a 2000 line encoder which gives 8000 counts per one motor revolution to the DSP, it is possible to accurately measure to and control at .045 degrees of rotation of the motor. In addition, a PMSM can run at low velocities with little or no vibration, which is desirable in dispense operations. Feed motor 175 can also be a PMSM or a stepper motor.

Those skilled in the art will appreciate that multi-stage pump 100 shown in FIGURE 2A is a non-limiting example of a multi-stage pump and that other types of multi-stage pumps may implement embodiments disclosed herein without departing from the scopes and spirits of the invention disclosed herein. As an example, FIGURE 2B depicts a diagrammatic representation of another exemplary multi-stage pump according to one embodiment.

In FIGURE 2B, multi-stage pump 100 may comprise a plurality of components, including various valves 125, 130, 135, 140, 145, and 147, filter 120, pressure sensors 112 and 114, and dispense stage 110, similar to those shown and described above with reference to FIGURE 2A. In this example, feed stage 105 comprises a pressurized bottle or reservoir tank 118 in fluid communication with fluid source 15 (shown in FIGURE 1) and filter 120. Specifically, reservoir tank 118 is located downstream from fluid source 15 and upstream from filter 120. A process fluid may be directed from reservoir tank 118 to filter 120 by controlling inlet valve 125 and/or isolation valve 130. Pressure in reservoir tank 118 may be measured by a pressure sensor 114. This allows the control logic of multi-stage pump 100 (e.g., pump controller 20 shown in FIGURE 1) to gain knowledge on pressure in the process fluid at the fill side (e.g., feed stage 105) in real time, as explained below.

Notice that in FIGURE 2B, pressure sensor 114 is coupled to or mounted on a sidewall of reservoir tank 118 for detecting fluid pressure in reservoir tank 118. This sidewall location can avoid or minimize the possibility of pressure sensor 114 trapping air and hence avoid or minimize disturbance to the process fluid contained in reservoir tank 118. Preferably, pressure sensor 114 is mounted on the sidewall of reservoir tank 118 in a manner to allow air bubbles to surface more easily and escape out of reservoir tank 118 (e.g., when vent valve 143 is open). In some embodiments, pressure sensor 114 can be flush mounted to or at an angle on the sidewall of reservoir tank 118. The angle can be as steep as possible relative to the sidewall, for instance, about 5 - 10 degrees, and up to about 45 degrees from the sidewall of reservoir tank 118, to avoid trapping air. As shown in FIGURE 2B, in some embodiments, pressure sensor 114 can be mounted at or near the half-height of reservoir tank 118. In some embodiments, pressure sensor 114 can be mounted at or near the bottom of reservoir tank 118. In some embodiments, pressure sensor 114 can be mounted on the sidewall at any increased angle such that the sensing portion of pressure sensor 114 points upwards.

In operation, multi-stage pump 100 can include a number of segments including, but are not limited to, a ready segment, a dispense segment, a fill segment, a pre-filtration segment, a filtration segment, a vent segment, a purge segment, and a static purge segment. Examples of segments and associated valve and motor timings can be found in WO 2008/066589 A2, entitled "SYSTEM AND METHOD FOR OPERATION OF A PUMP"; U.S. Patent No. 8,025,486, entitled "SYSTEM AND METHOD FOR VALVE SEQUENCING IN A PUMP"; WO 2013/028542 A2, entitled "SYSTEM AND METHOD FOR DETECTING AIR IN A FLUID"; and WO 2012/054706 A2, entitled "METHOD AND SYSTEM FOR PUMP PRIMING".

By way of example, referring to FIGURE 2A, during the fill segment (which may also be referred to as a feed segment), inlet valve 125 is opened and feed stage pump 150 moves (e.g., pulls) feed stage diaphragm 160 to draw fluid into feed chamber 155. Once a sufficient amount of fluid has entered feed chamber 155, inlet valve 125 is closed. During the filtration segment, feed-stage pump 150 moves feed stage diaphragm 160 to displace fluid from feed chamber 155. Isolation valve 130 and barrier valve 135 are opened to allow fluid to flow through filter 120 to dispense chamber 185. Isolation valve 130 can be opened first (e.g., in the "pre-filtration segment") to allow pressure to build in filter 120 and then barrier valve 135 is opened to allow fluid flow into dispense chamber 185. During the filtration segment, dispense pump 180 can be brought to its home position which, in some cases, can be a variable home position.

Examples of a variable home position dispense system can be found in U.S. Patent No. 8,292,598, entitled "SYSTEM AND METHOD FOR A VARIABLE HOME POSITION DISPENSE SYSTEM" and WO 2006/057957 A2, entitled "SYSTEM AND METHOD FOR VARIABLE HOME POSITION DISPENSE SYSTEM". As an example, the home position for dispense stage diaphragm 190 can be selected, based on various parameters for a dispense cycle, such that dispense chamber 185 at dispense pump 180 contains a sufficient amount of fluid (which can be less than the maximum capacity of dispense chamber 185) to perform the various steps of the dispense cycle while minimizing the hold-up volume in dispense pump 180. Feed pump 150 can similarly be brought to a home position that defines a volume for an amount of fluid that is less than its maximum capacity.

As fluid flows into a chamber in a pump, the pressure of the fluid increases. In the example of FIGURE 2A, feed pump 150 includes a pressure sensor 114 coupled to feed chamber 155 for measuring the pressure of fluid at feed stage 105. Likewise, in the example of FIGURE 2B, feed stage 105 includes a pressure sensor 114 coupled to reservoir tank 118 for measuring the pressure of fluid at feed stage 105. Additionally, as shown in FIGURES 2A and 2B, dispense pump 180 includes a pressure sensor 112 coupled to dispense chamber 185 for measuring the pressure of fluid at dispense stage 110. The pressure sensors may be in communication with the control logic (e.g., pump controller 20) described above. The pressures measured by pressure sensor 112 and pressure sensor 114 can be used by the control logic to control the speed of various pumps and determine whether a dispense was a good dispense. These pressure sensors are configured to work under pressure and in vacuum and may be coated with an inert polymer, such as polytetrafluoroethylene (PTFE) based material, for example, Teflon by DuPont Co. Examples of suitable pressure sensors (which may also be referred to as pressure transducers) may include, but are not limited to, piezoresistive (piezoelectric) and capacitive pressure sensors, including ceramic and polymer pressure sensors manufactured by Metallux AG of Nellmersbach, Germany. Depending upon application, other types of sensors may also be used at the fill side and/or the dispense side. For example, a flow sensor such as an ultrasonic flowmeter may be used in addition to or in place of a pressure sensor.

Embodiments can regulate/control fluid pressure at both feed stage 105 and dispense stage 110 based at least in part on measurements received from sensors 112 and 114. For example, when the fluid pressure in dispense chamber 185 reaches a predefined pressure set point (e.g., as measured by pressure sensor 112) during a filtration segment, dispense pump 180 may begin to withdraw dispense stage diaphragm 190. In other words, dispense pump 180 is controlled to increase the available volume of dispense chamber 185 to allow fluid to flow into dispense chamber 185. This can be done, for example, by reversing dispense motor 200 at a predefined rate, causing the pressure in dispense chamber 185 to decrease.

When the fluid pressure in dispense chamber 185 falls below the set point (within the tolerance of the system), the motor rate of feed motor 175 can be increased to cause the pressure in dispense chamber 185 to rise and reach the set point. When the fluid pressure in dispense chamber 185 exceeds the set point (within the tolerance of the system), the motor rate of feed motor 175 can be decreased, leading to a lessening of pressure in downstream dispense chamber 185. The process of increasing and decreasing the speed of feed motor 175 can be repeated until dispense pump 180 reaches a home position, at which point both motors can be stopped.

In the above-referenced WO 2008/066589 A2, entitled "SYSTEM AND METHOD FOR OPERATION OF A PUMP," pressure measurements are taken by a pressure sensor at the dispense side ("dispense pressure"). Embodiments disclosed herein further include a pressure sensor for sensing fluid pressure at the feed (fill) side ("fill pressure"). The ability to detect the fill pressure and changes in the fill pressure at the fill side can be beneficial. For example, it may allow the system to detect a problem or issue before the dispense stage (e.g., air in the fill line or at the filter) and provide an early warning and/or take appropriate action to address or solve the problem or issue at hand.

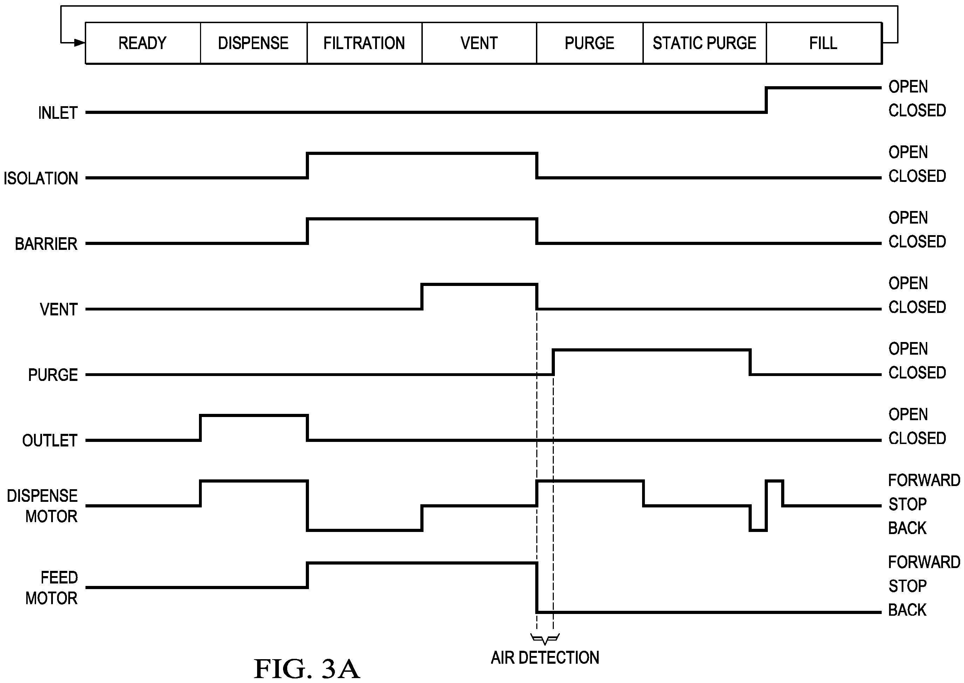

As an example, referring to FIGURE 3A which shows valve and dispense motor timings for various segments of the operation of multi-stage pump 100 of FIGURE 2, at the beginning of a vent segment, isolation valve 130 is opened and vent valve 145 opened. Feed pump 150 is controlled to apply pressure to the fluid to remove air bubbles from filter 120 through open vent valve 145. As shown in FIGURE 3A, barrier valve 135 can remain open during the vent segment and close at the end of the vent segment. If so, the pressure in filter 120 can be detected (e.g., by a controller such as pump controller 20 described above) because the pressure in dispense chamber 185, which can be measured by pressure sensor 112, can be affected by the pressure in filter 120. When barrier valve 135 is closed, the pressure in filter 120 can still be detected because the pressure in feed chamber 155, which can be measured by pressure sensor 114, can be affected by the pressure in filter 120.

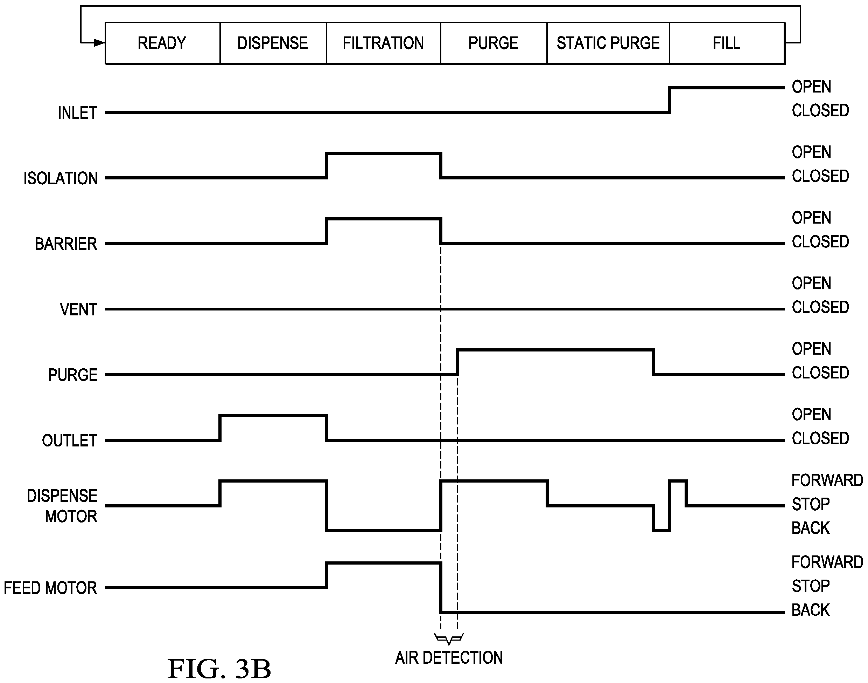

While several valves are shown in FIGURE 3A as closing simultaneously during segment changes, the closing of valves can be timed slightly apart (e.g., 100 milliseconds) to reduce pressure spikes. For example, between the vent segment and the purge segment, isolation valve 130 can be closed shortly before vent valve 145 is opened. It should be noted, however, other valve timings can be utilized in various embodiments. Additionally, several of the segments can be performed together (e.g., the fill/dispense stages can be performed at the same time, in which case, both the inlet and outlet valves can be open in the dispense/fill segment). It should be further noted that specific segments do not have to be repeated for each cycle. For example, the purge and static purge segments may not be performed every cycle. Similarly, the vent segment may not be performed every cycle, as exemplified in FIGURE 3B. Furthermore, any suitable valve and motor timings can be used.

Feed pump 150 can be controlled to cause venting to occur at a predefined rate, allowing for longer vent times and lower vent rates, thereby allowing for accurate control of the amount of vent waste. If feed pump 150 is a pneumatic style pump, a fluid flow restriction can be placed in the vent fluid path, and the pneumatic pressure applied to feed pump 150 (and measured by pressure sensor 114) can be increased or decreased in order to maintain a "venting" set point pressure, providing some control of an otherwise un-controlled method.

As illustrated in FIGURES 3A and 3B, an air detection test may be performed during a segment (e.g., at the start of a purge segment, as explained below). For example, to perform an air detection test on the dispense side, barrier valve 135, purge valve 140, and outlet valve 147 can be closed to isolate dispense chamber 185. Dispense motor 200 is controlled to bring dispense chamber 185 to a desired pressure (e.g., 5 pounds per square inch (psi)). Dispense motor 200 is then moved a fixed distance and the change (delta) in pressure (P) in dispense chamber 185 is determined. By determining the pressure change (delta P) for a fixed change in volume of isolated dispense chamber 185 (or other isolated portion of a pumping system), the amount of air in dispense chamber 185 (or the isolated portion of the pumping system including tubing up to output valve 147 or other valve prior to the nozzle) can be determined, as discussed in the above-referenced WO 2013/028542 A2, entitled "SYSTEM AND METHOD FOR DETECTING AIR IN A FLUID."

With pressure sensor 114 on the fill side, it is also possible to perform an air detection test on the fill side. In some embodiments, inlet valve 125 and isolation valve 130 can be closed to isolate feed chamber 155 (which can be referred to as an "isolated portion"). In some embodiments, inlet valve 125, vent valve 145, and barrier valve 135 can be closed to isolate feed chamber 155 and filter 120 (which together can also be referred to as an isolation portion). Fill motor 175 is controlled to bring the isolated portion to a desired pressure (e.g., 5 psi). Fill motor 175 is then moved a fixed distance and the change (delta) in pressure (P) in the isolated portion is determined. By determining the pressure change (delta P) for a fixed change in the volume of the isolated portion (or other isolated portion of a pumping system), the amount of air in feed chamber 155 (or, in feed chamber 155 and filter 120) can be determined.

In some embodiments, dispense motor 200 can be controlled to maintain a predefined pressure change (e.g., defined by a user via an interface to a pumping system). To achieve the predefined pressure change, a controller may determine an appropriate change in the available volume in dispense chamber 185 and control dispense motor 200 to move piston 192 accordingly. Again, this measure can be used to determine the amount of air in dispense chamber 185 or the isolated portion of the pumping system including tubing up to output valve 147 or other valve prior to the nozzle, as discussed in the above-referenced WO 2013/028542 A2, entitled "SYSTEM AND METHOD FOR DETECTING AIR IN A FLUID." In some cases, if the measure of detected air is less than a threshold amount, a purge and/or static purge segment can be skipped, shortening cycle time. If the amount of detected air is greater than a threshold, a warning or corrective action can be taken.

In some cases, during a purge segment, isolation valve 130 is closed, barrier valve 135 is closed, vent valve 145 is closed, purge valve 140 is open, and outlet valve 147 is closed. As illustrated in FIGURES 3A and 3B, there can be a delay before opening purge valve 140 during which dispense chamber 185 is isolated. Dispense pump 180 can apply pressure to the fluid in dispense chamber 185 so that the air detection test can be performed.

During the purge segment, when purge valve 140 is opened, dispense pump 180 applies pressure to the fluid in dispense chamber 185 to vent air bubbles through purge valve 140. During the static purge segment, dispense pump 180 is stopped, but purge valve 140 remains open to continue to vent air. Any excess fluid removed during the purge or static purge segments can be routed out of multi-stage pump 100 (e.g., returned to fluid source 15, reservoir tank 118, or discarded) or recycled to feed stage 105.

In some cases, as exemplified in FIGURES 3A and 3B, all the valves may be closed during the ready segment. In some cases, isolation valve 130 and barrier valve 135 can be opened and purge valve 140 closed so that feed pump 150 can reach ambient pressure of a fluid source (e.g., a source bottle or reservoir tank).

During the dispense segment, outlet valve 147 opens and dispense pump 180 applies pressure to the fluid in dispense chamber 185. Because outlet valve 147 may react to controls more slowly than dispense pump 180, outlet valve 147 can be opened first and some predetermined period of time later dispense motor 200 started. This prevents dispense pump 180 from pushing fluid through a partially opened outlet valve 147. Moreover, this prevents fluid moving up the dispense nozzle caused by the valve opening, followed by forward fluid motion caused by motor action. In some cases, outlet valve 147 can be opened and dispense pump 180 may begin to dispense simultaneously.

Other segments may also be performed. For example, a suckback segment can be performed to remove excess fluid in the dispense nozzle. During the suckback segment, outlet valve 147 can close and a secondary motor or vacuum can be used to suck excess fluid out of the outlet nozzle. Alternatively, outlet valve 147 can remain open and dispense motor 200 can be reversed to draw fluid back into dispense chamber 185. The suckback segment can help prevent dripping of excess fluid onto wafer 25.

The opening and closing of various valves can cause pressure spikes in the fluid. Closing of purge valve 140 at the end of the static purge segment, for example, can cause a pressure increase in dispense chamber 185. This can occur because each valve may displace a small volume of fluid when it closes. For instance, purge valve 140 can displace a small volume of fluid into dispense chamber 185 as it closes. Because outlet valve 147 is closed when the pressure increases occur due to the closing of purge valve 140, "spitting" of fluid onto a wafer may occur during the subsequent dispense segment if the pressure is not reduced. To release this pressure during the static purge segment, or an additional segment, dispense motor 200 may be reversed to back out piston 192 a predetermined distance to compensate for any pressure increase caused by the closure of barrier valve 135 and/or purge valve 140.

It should be noted that during the ready segment, the pressure in dispense chamber 185 can change based on the properties of the diaphragm, temperature or other factors. Dispense motor 200 can be controlled to compensate for this pressure drift.

By controlling pump operations at the dispense side as well as at the fill side based on real-time feedback from pressure sensors at the dispense pump and at the feed pump, embodiments of a multi-stage pump disclosed herein can provide gentle fluid handling characteristics and avoid potentially damaging pressure spikes. As discussed above, various pump control mechanisms and valve timings can further help to reduce deleterious effects of pressure on a process fluid. For example, valve and motor timings may be selected to reduce closing valves on an entrapped space.

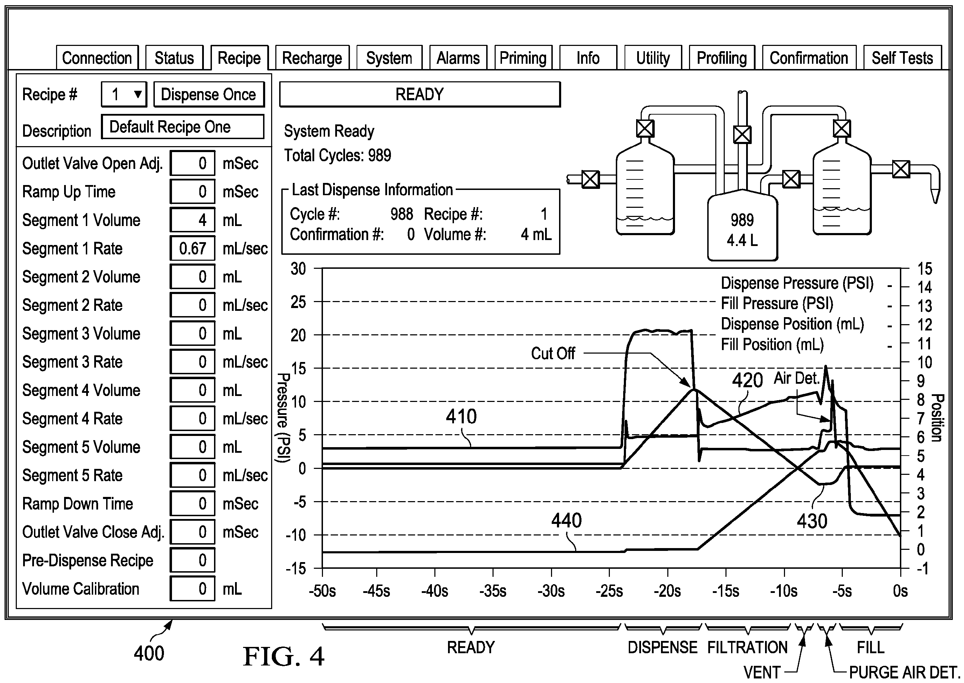

FIGURE 4 is a diagrammatic representation of a graphical user interface (GUI) 400 displaying a set of monitored data (e.g., monitored by a control logic of a pumping system such as pumping system 10 described above with reference to FIGURE 1) collected during a dispense cycle including ready, dispense, filtration, vent, purge, air detection, and fill segments. The monitored data may be displayed real-time, before, during, and/or after a dispense cycle is complete. GUI 400 can be provided by a pump controller (e.g., pump controller 20 described above with reference to FIGURE 1) or another computing device based on data received from the pump controller. In the embodiment illustrated, the monitored data includes the dispense pressure 410 (e.g., as determined from pressure sensor 112 of FIGURE 2A or 2B), fill pressure 420 (e.g., as determined by pressure sensor 114 of FIGURE 2A or 2B), the dispense motor position 430 (which is referred to in FIGURE 4 as dispense position and expressed in a displacement volume of milliliters) and feed motor position 440 (which is referred to in FIGURE 4 as fill position and expressed in a displacement volume of milliliters). One or more of the data sets can be compared to a baseline (reference cycle) to control operation of the pump, determine errors, determine whether a dispense was a "good" dispense, etc.

More specifically, a baseline profile may be established for one or more parameters. As an example, referring to FIGURE 1, during operation of pump 100, these parameters may be measured to create an operating profile for each parameter. The baseline profile for each parameter may then be compared with the operating profile at one or more corresponding points or portions for one or more parameters. An alarm condition may exist if the operating profile differs from the baseline profile by more than a certain tolerance. Otherwise, pump 100 may continue operating.

To establish a baseline profile with respect to certain parameters, a parameter may be measured during a baseline (reference) or "golden" run. In one embodiment, an operator or user of pump 100 may set up pump 100 to their specifications using liquid, conditions and equipment substantially similar, or identical, to the conditions and equipment with which pump 100 will be utilized during normal usage or operation of pump 100. Pump 100 can then be operated for a dispense cycle to dispense fluid according to a user's recipe. During this dispense cycle, the parameter may be measured substantially continuously, or at a set of points, to create an operating profile for that parameter. In one particular embodiment, the sampling of a parameter may occur at between approximately one millisecond and ten millisecond intervals.

The user may view operation parameters of pump 100 via GUI 400 during this dispense cycle. The dispense produced by pump 100 during this dispense cycle should be within tolerances or specifications such that defect free wafer or product can be produced. If the user is satisfied with both the pump operation and the dispense quality, the user may indicate through pump controller 20 that it is desired that the operating profile (e.g. the measurements for the parameter taken during the dispense cycle) should be stored and utilized as the baseline profile for the parameter for subsequent dispense operations by pump 100. In this manner, a baseline profile for one or more pump operation parameters may be established for pump 100.

To detect various problems that may have occurred during operation of pump 100, an operating profile for a parameter created during operation of pump 100 may then be compared to a baseline profile corresponding to the same parameter. These comparisons may be made by pump controller 20, a management station or other computing device in communication with pump controller 20 or other computing device and can take a variety of forms. For example, the value of the parameter at one or more points of the baseline profile may be compared with the value of the parameter at substantially equivalent points in the operating profile; the average value of the baseline profile may be compared with the average value of the operating profile; the average value of the parameter during a portion of the baseline profile may be compared with the average value of the parameter during substantially the same portion in the operation profile; etc.

It will be understood that the type of comparisons described are exemplary only, and that any suitable comparison between the baseline profile and an operating profile may be utilized. In fact, in many cases, more than one comparison, or type of comparison, may be utilized to determine if a particular problem or condition has occurred. It will also be understood that the type(s) of comparison utilized may depend, at least in part, on the condition attempting to be detected. Similarly, the point(s), or portions, of the operational and baseline profiles compared may also depend on the condition attempting to be detected, among other factor. Additionally, it will be realized that the comparisons utilized may be made substantially in real time during operation of a pump during a particular dispense cycle, or after the completion of a particular dispense cycle.

If the comparison results in a difference outside of a certain tolerance an alarm may be registered at pump controller 20. This alarm may be indicated by pump controller 20, or the alarm may be sent to a tool controller (e.g., a pump track) interfacing with pump controller 20. As with the type of comparison discussed above, the particular tolerance utilized with a given comparison may depend on a wide variety of factors, for example, the point(s), or portions, of the profiles at which the comparison takes place, the process or recipe with which the user will use pump 100, the type of fluid being dispensed by pump 100, the parameter(s) being utilized, the condition or problem it is desired to detect, user's desire or user tuning of the tolerance, etc. For example, a tolerance may be a percentage of the value of the parameter at the comparison point of the baseline profile or a set number, the tolerance may be different when comparing a baseline profile with an operating profile depending on the point (or portion) of comparison, there may be a different tolerance if the value of the operating profile at a comparison point is lower than the value of the parameter at the comparison point of the baseline profile than if it is above the value, etc.

The data for the baseline profile can include all or a portion of the data sampled during the run of the pump used to establish the baseline profile. For example, if the pump samples pressure every millisecond, the baseline profile may include measurements sampled every 20 milliseconds to reduce storage requirements. During operation of pump 100, the parameters may be measured to create an operating profile for a parameter. Again, the data for the operating profile may represent all of the sampled data for that parameter for an operation or some subset thereof (e.g., data collected every 5 milliseconds or other time period). According to one embodiment, a goodness-of-fit measure for a dispense cycle, particular segments, combinations of segments or portions of a cycle or segment may then be determined for the operating profile using the baseline profile. For example, an R-Squared measure (i.e., the coefficient of determination, which is a number that indicates how well the operating profile data fit the baseline profile data) can be determined for operating profile data collected every 5 milliseconds using corresponding baseline profile data. If the goodness-of-fit measure is outside of an acceptable range, an alarm condition may exist.

In the above example, data stored every 5 milliseconds is used to test goodness-of-fit while the pump may sample the parameter at a higher rate (e.g., every millisecond). Data stored at different rates, say every millisecond or every 30 milliseconds, may be used, but as the time between stored samples decreases memory usage goes up and as the time increases the accuracy of the goodness-of-fit measure can decrease. Therefore, the frequency at which data is stored for the goodness-of-fit measure can be selected to balance data storage capabilities and accuracy of the goodness-of-fit measure. Furthermore, while the R-Squared measure is used as the goodness-of-fit measures in the above examples, other measures of fit may be used.

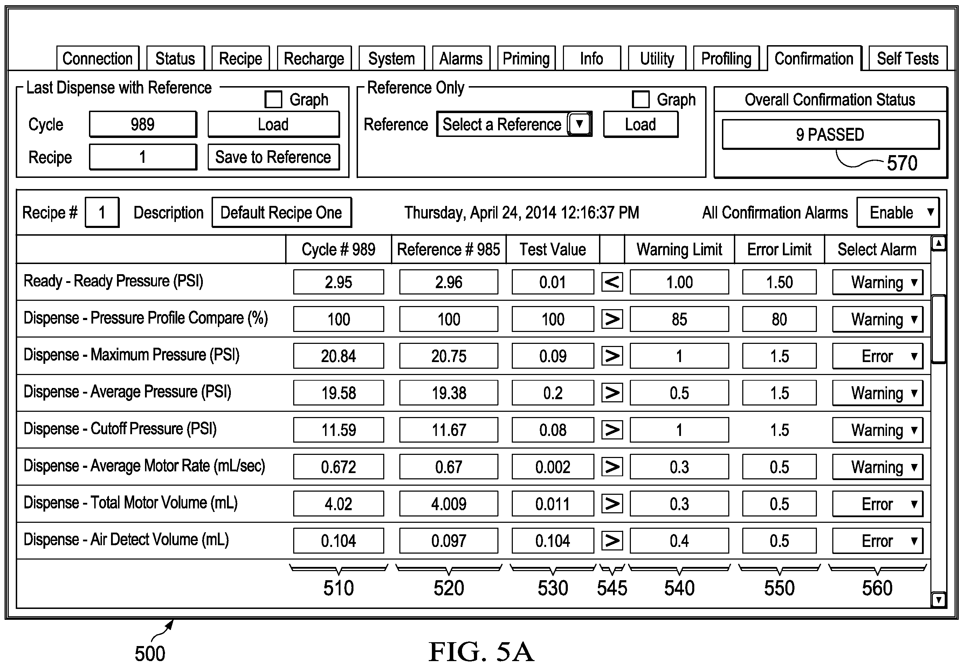

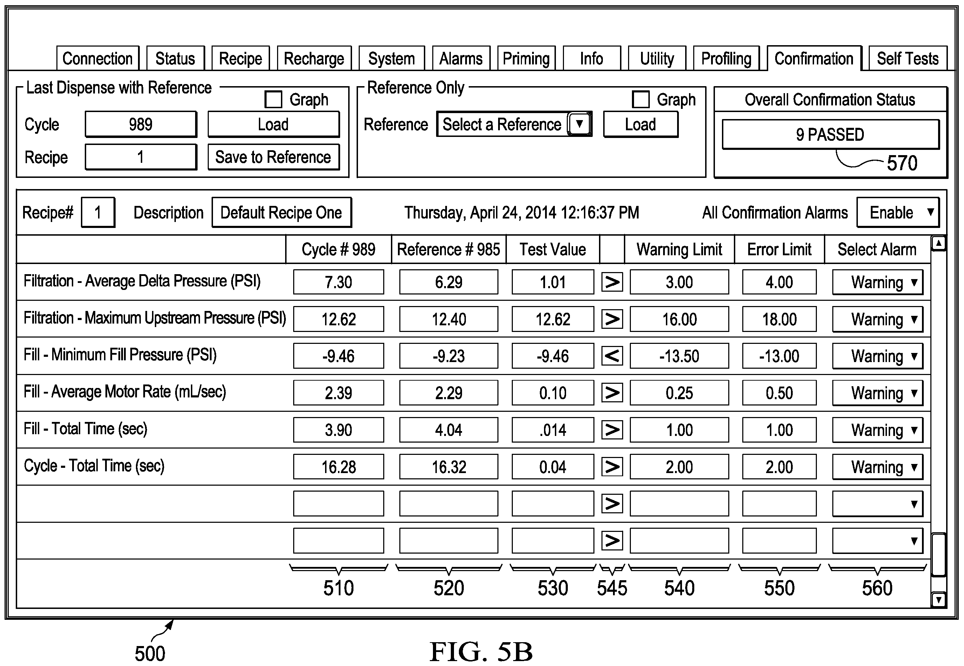

FIGURES 5A and 5B depict diagrammatic representations of one embodiment of a graphical user interface 500 displaying an example set of monitored data. As illustrated in FIGURES 5A and 5B, data for an operational cycle of a pump (e.g., multi-stage pump 100 described above with reference to FIGURE2A) is displayed in column 510 and data for a reference (baseline) cycle is displayed in column 520. The test value (i.e., the value tested against warning or error limits) is provided in column 530. Additionally, user specified warning and error limits are displayed in columns 540 and 550. The test being applied (greater than, less than, etc.) is displayed in column 545. In column 560, a user can select an alarm type when a test value fails an error test. In some embodiments, there can be four alarm types: information alarms, warning alarms, error alarms (which the system will complete the current cycle as best as it can, but it will not allow another cycle get started), and critical alarms (which the system will shut down the current cycle and stop the pump).

In one example, a warning can mean that a warning action is taken, while an error can mean that an error action is taken. The warning and error actions may be user configurable in some embodiments. By way of example, but not of limitation, a warning action may include sending a notification to a user that a warning condition occurred without stopping operation, whereas an error action may include sending a notification and preventing further operation (or preventing the next cycle of the pump). In this way, the pumping system can communicate its operating conditions with the pump track as often and as early as appropriate so that the pump track does not unnecessarily send another wafer for processing.

By way of example, but not of limitation, the following comparisons are illustrated in GUI 500:

Ready - Ready Pressure (pounds per square inch (PSI)): a system setting to pressurize a chamber (e.g., a dispense chamber) at the start of a dispense segment or an air detection test. This pump operation parameter can be set at about 3 psi or lower (e.g., about 1 psi). In some cases, setting the ready pressure at about 3 psi can prevent backlash from occurring at a dispense chamber. Those skilled in the art will appreciate that setting the ready pressure at 0 psi or at a negative pressure could also be advantageous in some applications.

Dispense - Pressure Profile Compare (%): the goodness-of-fit of the dispense pressure profile for the dispense segment of the cycle-of-interest (e.g., cycle 989) compared to the baseline dispense pressure profile (e.g., cycle 985), also referred to as "dispense confirmation." As described above, in one embodiment, this can be done using an R-Squared measure which can be determined by comparing operating profile data collected every 5 milliseconds with corresponding baseline profile data. The goodness-of-fit value acts as the test value and is compared to goodness-of-fit warning or error thresholds. In this example, if the goodness-of-fit of the cycle of interest is less than 85, a warning can be generated, if the goodness-of-fit is less than 80, an error can be generated. However, because "warning" is selected in the alarm type, a warning is generated even if the goodness-of-fit value falls below the error threshold. The goodness-of-fit of fill pressure, motor positions or other parameters can also be evaluated. Goodness-of-fit of a parameter may be evaluated for the cycle as whole, other segments, combinations of segments or other portions of the cycle. A warning or error may indicate air in the dispense chamber, changes in the outlet valve timing, mechanical problems with the pump or other issues.

Dispense - Maximum Pressure (PSI): the maximum pressure experienced in the dispense chamber during the dispense segment. The test value can be the difference or a comparison between the maximum dispense pressure of the cycle-of-interest and the reference cycle. Similar tests can be performed for the maximum, minimum, average, etc. dispense pressure in any other segment or combination of segments or the maximum, minimum, average, etc. fill (upstream) pressure in any segment or combination of segments. An error or warning can indicate changes in outlet valve timing, blockages in an outlet line, air in the dispense chamber, a failure of the outlet valve to open, mechanical problems with the pump or other issues.

Dispense - Average Pressure (PSI): the average pressure during a dispense cycle. The test value can be the difference or a comparison between the average dispense pressure of the cycle-of-interest and the reference cycle. Similar tests can be performed for the maximum, minimum, average, etc. dispense pressure in any other segment or combination of segments or the maximum, minimum, average, etc. fill pressure in any segment or combination of segments. An error or a warning may indicate changes in process fluid viscosity, a failure of the outlet valve to open or other issues.

Dispense - Cut Off Pressure (PSI): the pressure measured in the dispense chamber when the fluid stream is cut off at the nozzle. As an example, 250 microseconds (ms) after the dispense ends, the cut off pressure is the average pressure measured in the dispense chamber over the next 100 ms. Generally, the cut off pressure is noticeable as a small leveling off in the dispense pressure when the outlet valve closes (e.g., see FIGURE 4). The cut off pressure will vary depending upon slight timings in valve and motor timings. The test value can be the difference between the cut off pressure in the cycle-of-interest and the reference cycle. An error or a warning may indicate changes in the outlet valve close timing, mechanical problems with the pump or other issues.

Dispense - Average Motor Rate (milliliter per second (mL/Sec)): the average motor rate of the dispense motor during the dispense segment. The test value can be the difference or a comparison between the average motor rate during the dispense segment of the cycle-of-interest and the reference cycle. Similar tests can be performed for the average, maximum, minimum or other measure dispense motor rate in any other segment or combination of segments or the average, maximum, minimum or other measure of feed motor rate in any segment or combination of segments. An error or a warning may indicate recipe changes or other issues.

Dispense - Total Motor Volume (milliliter (mL)): the amount the dispense motor moved during the dispense segment. The test value can be the difference or a comparison between the amount the dispense motor moved during the dispense segment of the cycle-of-interest and the reference cycle. Similar tests can be performed for dispense motor movement in any other segment or combination of segments or movement of the feed motor in any segment or combination of segments. An error or a warning may indicate recipe changes or other issues.

Dispense - Air Detect Volume (mL): determines an amount that a motor moved to cause a predetermined change in pressure in a chamber (e.g., the dispense chamber at the dispense side). As discussed in the above-referenced WO 2013/028542 A2, entitled "SYSTEM AND METHOD FOR DETECTING AIR IN A FLUID," such a test can be used to determine if there is air in the dispense chamber or lines leading to the dispense nozzle. The test value can be the difference or a comparison between the amount of air detected during the air detection test for the cycle-of-interest and the reference cycle. Because the output valve may be located some distance from the pump through tubing, the air detection test can help identify bubbles or air in the dispense line, leaks or other issues. As such, air detection can be important because it can detect what is missing from a dispense confirmation (e.g., air detection can detect air and/or problems that the R-squared measure or the goodness-of-fit measure cannot detect). In one embodiment, the quality of this air detection test can be further enhanced with an anti-backlash mechanism mounted on a piston that eliminates or reduces backlash at the start of a dispense. A suitable anti-backlash mechanism can be found in the above-referenced U.S. Provisional Application No. 62/004,117, filed May 28, 2014, and International Application No. PCT/US2015/2XXXX, filed May 28, 2015, entitled "ANTI-BACKLASH MECHANISM FOR MOTOR-DRIVEN COMPONENTS IN PRECISION SYSTEMS AND APPLICATIONS". Since air detection is driven by the movement of the piston, the elimination/reduction of backlash caused by the movement of the piston means that the test value would more accurately reflect the amount of air detected, rather than possibly affected by some backlash.

Fill - Minimum Fill Pressure (PSI): the minimum pressure experienced in the feed chamber during the fill segment. The test value can be the difference or a comparison between the minimum fill pressure of the fill segment of the cycle-of-interest and the reference cycle. A discrepancy or difference in minimum fill pressure between a cycle-of-interest and reference cycle may indicate clogging in lines or other problem that can be overcome for example by the pump asserting a greater vacuum (negative pressure) to draw in fluid. A discrepancy or difference may also indicate mechanical problems with the pump, viscosity changes or other issues. Similar tests can be performed for the maximum, minimum, average, etc. fill pressure in any other segment or combination of segments or the maximum, minimum, average, etc. dispense pressure in any segment or combination of segments.

Filtration - Pressure Profile Compare (%): the goodness-of-fit of the fill pressure profile for the filtration segment of the cycle-of-interest (e.g., cycle 989) compared to the baseline fill pressure profile (e.g., cycle 985), also referred to as "filtration confirmation." The goodness-of-fit value (e.g., an R-Squared measure) acts as the test value and is compared to goodness-of-fit warning or error thresholds. In this example, if the goodness-of-fit measure of the cycle of interest is less than 85% (or some other measure), a warning can be generated, and if the goodness-of-fit measure is less than 80%, an error can be generated. However, because "warning" is selected in the alarm type, a warning is generated even if the goodness-of-fit value falls below the error threshold. The fill pressure profile may be similarly evaluated for other segments, combinations of segments or a cycle as a whole. Again, this is possible because fluid pressure at the feed stage can now be detected (e.g., via pressure sensor 114 described above with references to FIGURES 2A and 2B). An error or a warning may indicate air in the fill chamber, air in the dispense chamber, a blockage in the inlet line, viscosity changes, mechanical issues with the pump, or other issues.

Filtration - Average Delta Pressure (PSI): the difference in pressure between the downstream (dispense) side and the upstream (fill) side. As those skilled in the art will appreciate, pressure drop (i.e., the difference in pressure between two points of a fluid carrying network) can occur when frictional forces, caused by the resistance to flow, act on a fluid as it flows through a tube. Thus, if the pressure measured by a pressure sensor at the fill side (e.g., pressure sensor 114 described above with reference to FIGURES 2A and 2B) raises or drops outside of an acceptable range or limit (e.g., 1 psi), it may be an indication of something is wrong, for instance, rush of air, air locked inside a filter membrane that did not get vented, a filter clogs due to particulates accumulated over time, or it may be an indication that something is wrong with the filter itself or that some other events have occurred (e.g., changing the filter, a leak of the filter membrane due to a ripped opening or gradual degradation, etc.).

Filtration - Maximum Upstream Pressure (PSI): the maximum pressure experienced in the feed chamber during the filtration segment. The test value can be the difference or a comparison between the maximum fill pressure of the filtration segment of the cycle-of-interest and the reference cycle. Similar tests can be performed for the maximum, minimum, average, etc. upstream pressure in any other segment or combination of segments or the maximum, minimum, average, etc. dispense pressure in any segment or combination of segments. An error or a warning can indicate filter clogging, viscosity changes, mechanical problems with the pump or other issues.

Fill - Average Motor Rate (milliliter per second (mL/sec)): a user configurable parameter for fill control. For example, a user can specify that the fill pressure (e.g., as measured by pressure sensor 114 described above with reference to FIGURES 2A and 2B) should not drop below a limit or threshold (i.e., a minimum fill pressure). As an example, if the minimum fill pressure is set at -4 psi and the fill pressure reaches -4 psi (e.g., due to a change in viscosity of the process fluid under processing), the pumping system may change the average motor rate to maintain the fill pressure at or above the minimum fill pressure. This parameter allows a user to specify a limit by which the pumping system can change the motor rate. For example, suppose the pumping system starts the motor at 1 mL/sec, the fill pressure is set to -2 psi, and the fill rate is set to 1 mL/sec. To maintain the fill pressure at or above -2 psi during a fill segment, the pumping system checks the average motor rate limit and changes the motor rate to .5 mL/sec without shutting down the operation. As this example illustrates, the pumping system is allowed to change the motor rate (as constrained by the average motor rate limit) and send out an alarm about the change while still running the cycle. This allows the pumping system to early detect any fill issues, control the fill pressure accordingly (e.g., by dropping the motor rate), and send out an appropriate alarm. In response to such an alarm, an operator may determine to stop running any more wafers or to accept the current operating profile and run with it. As those skilled in the art will appreciate, when pressure is maintained, a change in viscosity may be accurately reflected by the motor rate. Thus, an operator may decide to save the current fill pressure profile (e.g., -2 psi fill pressure) as a new reference profile and allow the pumping system to maintain the .5 mL/sec motor rate.

Fill - Total Time (sec): the total time for a fill segment. This is inversely correlated to the average motor rate. If the motor rate slows down, the total time needed to complete a fill segment will go up. Similar to the average motor rate parameter described above, this parameter can be used to monitor the fill pressure. In some cases, so long as the fill pressure is maintained/controlled, the pumping system may continue to operate. Nevertheless, the pumping system may send an alarm to the pump track and may disable the operation when the total time exceeds a predefined threshold.

Cycle - Total Time (sec): the total time for a dispense cycle. The time for fill and filtration segments may vary and thus the time for the total cycle can change. This parameter can help detect issues that may otherwise be missed. For example, each individual segment in a cycle may operate within an acceptable tolerance. As such, no alarm was raised. However, the total cycle time exceeds the wafer processing time. This indicates that one or more segments may need to be adjusted so that the margin of the acceptable tolerance would be smaller.

Other tests may also be performed. By way of example, but not limitation, tests can include output from downstream flow sensor as a variable or data input for dispense confirmation. The various tests can help alert the customer to problems before a bad dispense occurs (e.g., clogging during fill, clogging of the filter during filtration, air in the dispense line) and when a bad dispense occurs to prevent further bad dispenses.

Portion 570 can display an overall result of a dispense cycle, including the number of tests passed and a color coding or other visual indicator of whether the cycle was considered a good dispense cycles. In some cases, the visual indicator may correlate to a level of certainty that the dispense cycle was a good dispense cycle based on the number of tests passed, the amount by which a test was failed or other criteria. For example, green may be used if there is a high certainty that the dispense cycle was good, yellow if there is less certainty and red if it is likely the dispense cycle was not good.

The ability for a pumping system disclosed herein to conduct various tests, perform statistical analyses, and provide real time results (monitored data) to a pump track and/or an operator via a user interface is one of many benefits provided by embodiments disclosed herein. Particularly, a pressure sensor positioned at the feed stage can provide the pumping system with additional pressure information that was not available in prior pumping systems. Pressure information at the fill side can be useful in many applications, including filtration confirmation described above. Another beneficial use of pressure information at the fill side may be in priming a filter with a negative or reduced pressure.

As described in WO 2006/116385 A1, entitled "METHOD AND APPARATUS FOR TREATING FLUIDS TO REDUCE MICROBUBBLES", a filter may have surface features such as pores and crevices in a filter membrane that trap or nucleate microbubbles. These microbubbles, like particles in a process fluid, can cause defects on semiconductor wafer surfaces. Thus, a filter may first be subject to a reduced pressure to remove gas (in the form of microbubbles) from the filter's nucleating surface features and then contacted with a liquid. This is one example of priming a pump filter. As discussed in the above-referenced WO 2012/054706 A2, entitled "METHOD AND SYSTEM FOR PUMP PRIMING," a pump filter can be primed according to a variety of methods.

According to one embodiment, a filter priming routine can include a negative or reduced pressure priming segment. In a reduced pressure priming segment, a negative pressure can be asserted on a filter from an upstream side (e.g., a feed stage). This filter priming routine does not need to be performed every cycle (although it could be). It can be performed when a filter is first installed in a pump system.

By way of example, but not of limitation, referring to FIGURE 2A, a fluid can be introduced to filter 120 from feed stage 105. Vent valve 145, barrier valve 135, and inlet valve 125 can be closed. Isolation valve 130 can be opened so that feed chamber 155 and filter 120 are in fluid communication to create an entrapped space that includes filter 120 and feed chamber 155. Feed stage motor 175 may be controlled to retract feed diaphragm 160 of piston 165 until a desired negative pressure is achieved as detected, for example, by pressure sensor 114.

More specifically, one or more levels of upstream negative pressure for one or more periods of time may be applied to soak the filter with the fluid at a reduced pressure (also referred to as the "soak pressure"), which acts to degas or remove gas or bubbles from the fluid in the filter. In some embodiments, the timing (also referred to as the "soak time") and pressure(s) for a reduced pressure soak segment may be user-selectable. The ability to set soak pressure and soak time is new. In other cases, one or more levels of positive pressure may be applied to pressure soak the filter (e.g., in the same priming routine or a different priming routine).

In pumping systems that do not have a pressure sensor on the fill side, pressurization is performed on the dispense side. However, applying pressurization on the dispense side is not always feasible or desirable, particularly when applying a negative pressure, for instance, at -10 psi. One reason is that the dispense line can be very long and pulling a huge vacuum in this line may contaminate the fluid with microbubbles.

Embodiments disclosed herein include a pressure sensor at the fill side. Barrier valve 135 can be closed so the fluid on the dispense side is not exposed to the soak pressure. A soak pressure (e.g., -5 psi) can be applied on the filter which acts to de-gas the fluid in the filter without contaminating the fluid. A benefit of low pressure is that it allows microbubbles to form bigger bubbles which are more buoyant. When pressure comes back up in the next segment, these bigger bubbles tend not to go back into the fluid and, thus, can be more easily vented out.

As discussed above, the dispense quality may affect the thickness and uniformity of the film to be applied on the wafer surface. The precision control and gentle handling characteristics of the pumping system disclosed herein can help to ensure a good dispense. Priming a filter with reduced pressure applied from the fill side can further enhance the quality of the resulting product by reducing or eliminating defects which can be hard to detect even with a good dispense. It can be hard to detect defects in prior systems because particulates introduced from a filtration segment may go unnoticed for a while and finally show up in the wafer defect rate. In embodiments disclosed herein, information from the pressure sensor on the fill side can be used to infer or otherwise determine whether a filtration is a "good filtration." This information allows for early detection of any problem (e.g., the fill motor has stalled), minimizes the chance of creating defects in the filtration cycle in the first stage (and hence better filtration), and increases the dispense quality in the second stage (and hence better dispense).

Furthermore, by controlling a motor to provide a reduced or negative pressure in soaking and priming the filter, embodiments can advantageously eliminate the need for an external vacuum source, attendant flow paths, and associated valves. As described above, the negative or reduced pressure can be detected by the pressure sensor coupled to the feed chamber, which is in fluid communication with the filter. The detected pressure information can be provided to the control logic associated with the pumping system and/or the pump track which, in turn, can interpret the pressure information and use it to monitor the reduced pressure priming segment in real time.

It can be noted that a vacuum soak segment may be a portion of a larger priming routing having one or more other segments. For example, a "Soak" cycle can have a reduced pressure soak segment and one or more of a vent segment, purge-to-vent, filtration, purge-to-inlet, purge, forward pressure, forward flush, backward pressure, backward flush or other segments. One embodiment of a Soak cycle includes a vent segment with isolation valve 130 and vent valve 145 open, followed by a reduced pressure soak segment with vent valve 145 closed and the feed pump asserting a negative pressure. A Soak cycle can be combined with other cycles to create a priming routine. While discussed primarily in the context of priming a filter, a reduced pressure soak segment can also be implemented as part of a dispense cycle.

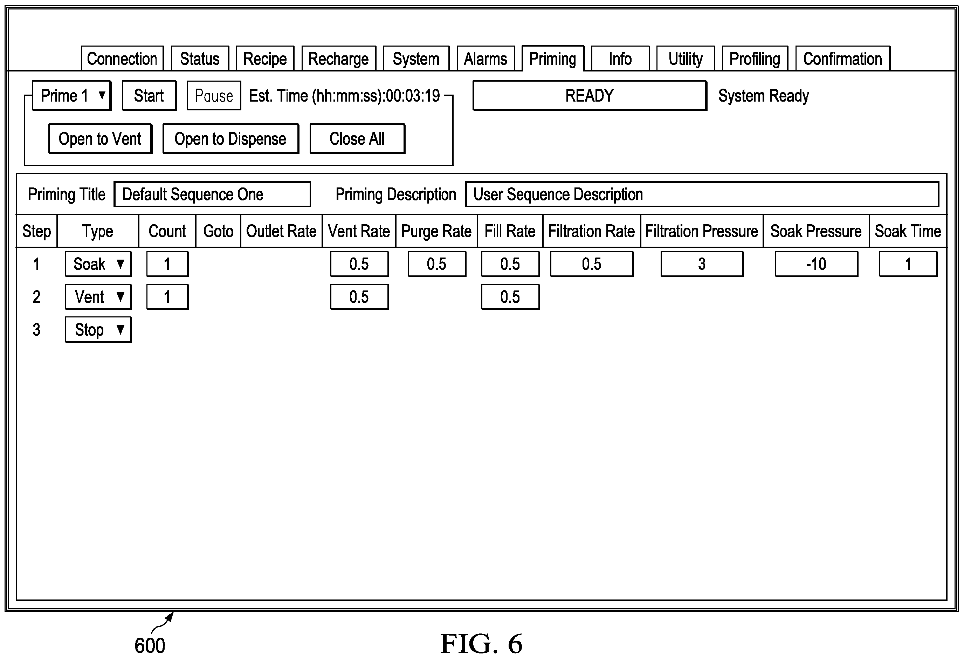

FIGURE 6 is a graphical user interface 600 illustrating a user configuring one embodiment of a Soak cycle to include a Soak segment at which a filter is soaked at a negative or reduced pressure (e.g., such as -10 psi). In some cases, a positive pressure could be specified so that the Soak segment is a pressure soak segment.

As will be appreciated, some routines, methods, steps, operations or portions thereof described herein can be implemented through control logic, including computer executable instructions stored on a computer readable medium, hardware, firmware or a combination thereof. The control logic can be adapted to direct an information processing device to perform a set of steps disclosed in the various embodiments. Some embodiments may be implemented by using software programming or code in one or more digital computers, by using application specific integrated circuits, programmable logic devices, field programmable gate arrays, optical, chemical, biological, quantum or nanoengineered systems, components and mechanisms. Based on the disclosure and teachings provided herein, a person of ordinary skill in the art will appreciate other ways and/or methods to implement the invention.

Any particular step, operation, method, routine, operation or portion thereof can execute on a single computer processing device or multiple computer processing devices, a single computer processor or multiple computer processors. Data may be stored in a single storage medium or distributed through multiple storage mediums, and may reside in a single database or multiple databases (or other data storage). The sequence of operations described herein can be interrupted, suspended, or otherwise controlled by another process, such as an operating system, kernel, etc. The routines can operate in an operating system environment or as stand-alone routines.

Embodiments of routines, methods, steps, operations or portions thereof can be implemented in one or more computer communicatively coupled to a network (for example, the Internet, an intranet, an internet, a WAN, a LAN, a SAN, etc.), another computer, or in a standalone computer. As is known to those skilled in the art, the computer can include a CPU or processor, memory (e.g., primary or secondary memory such as RAM, ROM, HD or other computer readable medium for the persistent or temporary storage of instructions and data) and one or more I/O device(s). The I/O devices can include a keyboard, monitor, printer, electronic pointing device (for example, mouse, trackball, stylus, etc.), touch screen or the like. In embodiments, the computer has access to at least one database on the same hardware or over the network.

As used herein, the terms "comprises," "comprising," "includes," "including," "has," "having" or any other variation thereof, are intended to cover a non-exclusive inclusion. For example, a process, article, or apparatus that comprises a list of elements is not necessarily limited to only those elements but may include other elements not expressly listed or inherent to such process, article, or apparatus.

Further, unless expressly stated to the contrary, "or" refers to an inclusive or and not to an exclusive or. That is, the term "or" as used herein is generally intended to mean "and/or" unless otherwise indicated. For example, a condition A or B is satisfied by any one of the following: A is true (or present) and B is false (or not present), A is false (or not present) and B is true (or present), and both A and B are true (or present).

As used herein, a term preceded by "a" or "an" (and "the" when antecedent basis is "a" or "an") includes both singular and plural of such term unless the context clearly dictates otherwise. Also, as used in the description herein, the meaning of "in" includes "in" and "on" unless the context clearly dictates otherwise.

Additionally, any examples or illustrations given herein are not to be regarded in any way as restrictions on, limits to, or express definitions of, any term or terms with which they are utilized. Instead, these examples or illustrations are to be regarded as being described with respect to one particular embodiment and as illustrative only. Those of ordinary skill in the art will appreciate that any term or terms with which these examples or illustrations are utilized will encompass other embodiments which may or may not be given therewith or elsewhere in the specification and all such embodiments are intended to be included within the scope of that term or terms. Language designating such non-limiting examples and illustrations includes, but is not limited to: "for example," "for instance," "e.g.," "in one embodiment."

Reference throughout this specification to "one embodiment," "an embodiment," or "a specific embodiment" or similar terminology means that a particular feature, structure, or characteristic described in connection with the embodiment is included in at least one embodiment and may not necessarily be present in all embodiments. Thus, respective appearances of the phrases "in one embodiment," "in an embodiment," or "in a specific embodiment" or similar terminology in various places throughout this specification are not necessarily referring to the same embodiment. Furthermore, the particular features, structures, or characteristics of any particular embodiment may be combined in any suitable manner with one or more other embodiments. It is to be understood that other variations and modifications of the embodiments described and illustrated herein are possible in light of the teachings herein and are to be considered as part of scope of the invention, as defined by the respective subject-matter of the appended patent claims.

Although the invention has been described with respect to specific embodiments thereof, these embodiments are merely illustrative, and not restrictive of the invention. The description herein of illustrated embodiments of the invention is not intended to be exhaustive or to limit the invention to the precise forms disclosed herein (and in particular, the inclusion of any particular embodiment, feature or function is not intended to limit the scope of the invention to such embodiment, feature or function). Rather, the description is intended to describe illustrative embodiments, features and functions in order to provide a person of ordinary skill in the art context to understand the invention without limiting the invention to any particularly described embodiment, feature or function. While specific embodiments of, and examples for, the invention are described herein for illustrative purposes only, various equivalent modifications are possible within the scope of the invention, as defined by the respective subject-matter of the appended patent claims. As indicated, these modifications may be made to the invention in light of the foregoing description of illustrated embodiments of the invention and are to be included within said scope of the invention, as defined by the respective subject-matter of the patent claims. Thus, while the invention has been described herein with reference to particular embodiments thereof, a latitude of modification, various changes and substitutions are intended in the foregoing disclosures, and it will be appreciated that in some instances some features of embodiments of the invention will be employed without a corresponding use of other features without departing from said scope of the invention. Therefore, many modifications may be made to adapt a particular situation or material to the essential scope of the invention, as defined by the respective subject-matter of the appended patent claims.

In the description herein, numerous specific details are provided, such as examples of components and/or methods, to provide a thorough understanding of embodiments of the invention. One skilled in the relevant art will recognize, however, that an embodiment may be able to be practiced without one or more of the specific details, or with other apparatus, systems, assemblies, methods, components, materials, parts, and/or the like. In other instances, well-known structures, components, systems, materials, or operations are not specifically shown or described in detail to avoid obscuring aspects of embodiments of the invention. While the invention may be illustrated by using a particular embodiment, this is not and does not limit the invention to any particular embodiment and a person of ordinary skill in the art will recognize that additional embodiments are readily understandable and are a part of this invention.

Although the steps, operations, or computations may be presented in a specific order, this order may be changed in different embodiments. In some embodiments, to the extent multiple steps are shown as sequential in this specification, some combination of such steps in alternative embodiments may be performed at the same time. The sequence of operations described herein can be interrupted, suspended, or otherwise controlled by another process.

It will also be appreciated that one or more of the elements depicted in the drawings/figures can also be implemented in a more separated or integrated manner, or even removed or rendered as inoperable in certain cases, as is useful in accordance with a particular application. Additionally, any signal arrows in the drawings/figures should be considered only as exemplary, and not limiting, unless otherwise specifically noted. The scope of the disclosure should be determined by the following claims.

## Claims

1. A pumping system (10) comprising a multiple stage pump (100) and a computing device, the multiple stage pump comprising:
an inlet valve (125) for regulating ingress of a process fluid;
a feed stage portion (105) downstream from the inlet valve;
a filter (120) downstream from the feed stage portion;
a dispense stage portion (110) downstream from the filter; and
an outlet valve (147) for regulating egress of the process fluid;
wherein the feed stage portion comprises a feed stage pump (150); and
wherein the feed stage pump comprises a feed chamber (155, 118), a feed stage diaphragm (160) that moves within the feed chamber and displaces the process fluid in the feed chamber, a piston (165) that moves the feed stage diaphragm, a lead screw (170) coupled to the piston that causes the piston to actuate, and a feed motor (175) that drives the lead screw;
**characterized in that** the feed stage portion comprises a pressure sensor (114), wherein the pressure sensor is mounted on a sidewall of the feed chamber to detect fluid pressure in the feed chamber; and **in that** the feed stage pump is arranged to deliver, to the computing device, a fluid pressure in the feed chamber as detected by the pressure sensor; and further **in that** the computing device is arranged to perform a filtration confirmation by:
determining an operating fill pressure profile based at least in part on the fluid pressure in the feed chamber as detected by the pressure sensor;
comparing the operating fill pressure profile with a reference fill pressure profile; and
determining whether to generate an alarm based on the comparison.

2. The pumping system of claim 1, wherein the pressure sensor is mounted at an angle on the sidewall of the feed chamber relative to the sidewall of the feed chamber such that a sensing portion of the pressure sensor points upwards.

3. The pumping system of claim 1 or claim 2, wherein the computing device is arranged to use the fluid pressure in the feed chamber as detected by the pressure sensor in an air detection test, wherein the air detection test comprises isolating a portion of the multiple stage pump that includes the feed chamber, controlling the feed motor to bring the isolated portion to a first pressure, moving the feed motor a fixed distance, detecting a second pressure using the pressure sensor, and determining a differential pressure indicating a change between the first pressure and the second pressure, wherein the differential pressure correlates to an amount of air in the isolated portion that includes the feed chamber.

4. The pumping system of claim 3, wherein the isolated portion of the multiple stage pump includes the feed chamber and the filter.

5. The pumping system of any of claims 1 to 4, wherein the computing device is arranged to control the multiple stage pump in a filter priming routine to reduce the fluid pressure in the feed chamber as detected by the pressure sensor.

6. The pumping system of claim 5, wherein in the filter priming routine the computing device is arranged to determine whether an isolated portion of the multiple stage pump that includes the feed chamber and the filter has reached a negative or reduced pressure and to control the multiple stage pump to soak the filter in the process fluid at the negative or reduced pressure for a period of time to degas or remove gas or bubbles from the process fluid in the isolated portion of the multiple stage pump.

7. A pumping system according to any of claims 1 to 6, comprising:
a fluid source (15); and
a pump controller (20) communicatively connected to the multiple stage pump via one or more network communications links (40, 45).

8. The pumping system of claim 7, wherein either the pump controller comprises the computing device or the pump controller is in communication with the computing device.

9. The pumping system of any of claims 1 to 8, further comprising:
a graphical user interface (400, 500, 600) for displaying operating profiles for a plurality of pump operation parameters monitored by the pump controller.

10. The pumping system of claim 9, wherein the operating profiles include information collected during a dispense cycle including ready, dispense, filtration, vent, purge, air detection, and fill segments.

11. A method of operating the pumping system of any of claims 1 to 10, comprising performing a filtration confirmation by:
determining an operating fill pressure profile based at least in part on the fluid pressure in the feed chamber as detected by the pressure sensor;
comparing the operating fill pressure profile with a reference fill pressure profile; and
determining whether to generate an alarm based on the comparison.

12. The method of claim 11, comprising performing an air detection test by:
isolating a portion of the multiple stage pump that includes the feed chamber, controlling the feed motor to bring the isolated portion to a first pressure, moving the feed motor a fixed distance, detecting a second pressure using the pressure sensor, and determining a differential pressure indicating a change between the first pressure and the second pressure, wherein the differential pressure correlates to an amount of air in the isolated portion that includes the feed chamber.

13. The method of claim 12, wherein the isolated portion of the multiple stage pump includes the feed chamber and the filter.

14. The method of any of claims 11 to 13, comprising performing a filter priming routine by: determining whether an isolated portion of the multiple stage pump that includes the feed chamber and the filter has reached a negative or reduced pressure and soaking the filter in the process fluid at the negative or reduced pressure for a period of time to degas or remove gas or bubbles from the process fluid in the isolated portion of the multiple stage pump.

## Patentansprüche

1. Pumpsystem (10), umfassend eine Mehrstufenpumpe (100) und eine Computervorrichtung, wobei die Mehrstufenpumpe umfasst:
ein Einlassventil (125) zum Regeln des Eintritts eines Prozessfluids,
einen Zufuhrstufenabschnitt (105) stromabwärts des Einlassventils,
einen Filter (120) stromabwärts des Zufuhrstufenabschnitts,
einen Abgabestufenabschnitt (110) stromabwärts des Filters und
ein Auslassventil (147) zum Regeln des Austritts des Prozessfluids,
worin der Zufuhrstufenabschnitt eine Zufuhrstufenpumpe (150) umfasst und
worin die Zufuhrstufenpumpe eine Zufuhrkammer (155, 118), ein Zufuhrstufendiaphragma (160), das sich innerhalb der Zufuhrkammer bewegt und das Prozessfluid in der Zufuhrkammer verdrängt, einen Kolben (165), der das Zufuhrstufendiaphragma bewegt, eine mit dem Kolben verbundene Gewindespindel (170), die die Betätigung des Kolbens bewirkt, und einen Zufuhrmotor (175), der die Gewindespindel antreibt, umfasst,
**dadurch gekennzeichnet, dass** der Zufuhrstufenabschnitt einen Drucksensor (114) umfasst, worin der Drucksensor an einer Seitenwand der Zufuhrkammer befestigt ist, um den Fluiddruck in der Zufuhrkammer festzustellen, und darin dass
die Zufuhrstufenpumpe angeordnet ist, an die Computervorrichtung einen Fluiddruck in der Zufuhrkammer, wie von dem Drucksensor ermittelt, zu übermitteln, und weiter darin, dass die Computervorrichtung angeordnet ist, eine Filtrationsbestätigung durchzuführen durch:
Bestimmen eines Betriebsfülldruck-Profils, zumindest teilweise basierend auf dem Fluiddruck in der Zufuhrkammer, wie durch den Drucksensor ermittelt,
Vergleichen des Betriebsfülldruck-Profils mit einem Referenzfülldruck-Profil und
Bestimmen, ob basierend auf dem Vergleich ein Alarm erzeugt wird.

2. Pumpsystem nach Anspruch 1, worin der Drucksensor derart in einem Winkel an der Seitenwand der Zufuhrkammer bezüglich der Seitenwand der Zufuhrkammer angeordnet ist, dass der Messteil des Drucksensors nach oben zeigt.

3. Pumpsystem nach Anspruch 1 oder Anspruch 2, worin die Computervorrichtung angeordnet ist, um den Fluiddruck in der Zufuhrkammer, wie von dem Drucksensor bestimmt, in einem Luftbestimmungstest zu verwenden, wobei der Luftbestimmungstest das Isolieren eines Teils der Mehrstufenpumpe umfasst, der die Zufuhrkammer umfasst, Steuern des Zufuhrmotors, um den isolierten Teil auf einen ersten Druck zu bringen, Bewegen des Zufuhrmotors um eine festgesetzte Distanz, Bestimmen eines zweiten Drucks unter Verwendung des Drucksensors und Bestimmen eines Differenzdrucks, der eine Änderung zwischen dem ersten Druck und dem zweiten Druck anzeigt, wobei der Differenzdruck mit einer Menge an Luft in dem isolierten Teil, der die Zufuhrkammer umfasst, korreliert.

4. Pumpsystem nach Anspruch 3, worin der isolierte Teil der Mehrstufenpumpe die Zufuhrkammer und den Filter umfasst.

5. Pumpsystem nach einem der Ansprüche 1 bis 4, worin die Computervorrichtung angeordnet ist, die Mehrstufenpumpe in einer Filteransaug-Routine zu steuern, um den Fluiddruck in der Zufuhrkammer, wie mit dem Drucksensor ermittelt, zu reduzieren.

6. Pumpsystem nach Anspruch 5, worin die Computervorrichtung in der Filteransaug-Routine angeordnet ist, um zu ermitteln, ob ein isolierter Teil der Mehrstufenpumpe, der die Zufuhrkammer und den Filter enthält, einen negativen oder verminderten Druck erreicht hat, und die Mehrstufenpumpe zu steuern, um den Filter in dem Prozessfluid bei dem negativen oder verminderten Druck für einen Zeitraum zu tränken, um das Prozessfluid zu entgasen oder Gas oder Blasen aus dem Prozessfluid in dem isolierten Teil der Mehrstufenpumpe zu entfernen.

7. Pumpsystem nach einem der Ansprüche 1 bis 6, umfassend:
eine Fluidquelle (15) und
eine Pumpensteuerung (20), die über eine oder mehrere Netzwerk-Kommunikationsverbindungen (40, 45) kommunikativ mit der Mehrstufenpumpe verbunden ist.

8. Pumpsystem nach Anspruch 7, worin die Pumpensteuerung entweder die Computervorrichtung umfasst oder die Pumpensteuerung mit der Computervorrichtung in Verbindung steht.

9. Pumpsystem nach einem der Ansprüche 1 bis 8, weiter umfassend:
ein grafisches Benutzer-Interface (400, 500, 600) für die Anzeige von Betriebsprofilen für eine Vielzahl von Pumpenbetriebsparametern, die von der Pumpensteuerung überwacht werden.

10. Pumpsystem nach Anspruch 9, worin die Betriebsprofile Information umfassen, die während eines Abgabezyklus, einschließlich Fertig-, Abgabe-, Filtrations-, Belüftungs-, Spülungs-, Luftbestimmungs- und Füllabschnitten, gesammelt wurden.

11. Verfahren zum Betrieb eines Pumpsystems nach einem der Ansprüche 1 bis 10, umfassend das Ausführen einer Filtrationsbestätigung durch:
Bestimmen eines Betriebsfülldruck-Profils, zumindest teilweise basierend auf dem Fluiddruck in der Zufuhrkammer, wie durch den Drucksensor ermittelt,
Vergleichen des Betriebsfülldruck-Profils mit einem Referenzfülldruck-Profil und
Bestimmen, ob basierend auf dem Vergleich ein Alarm erzeugt wird.

12. Verfahren nach Anspruch 11, umfassend das Durchführen eines Luftbestimmungstests durch:
Isolieren eines Teils der Mehrstufenpumpe, der die Zufuhrkammer umfasst, Steuern des Zufuhrmotors, um den isolierten Teil auf einen ersten Druck zu bringen, Bewegen des Zufuhrmotors um eine festgesetzte Distanz, Bestimmen eines zweiten Drucks unter Verwendung des Drucksensors und Bestimmen eines Differenzdrucks, der eine Änderung zwischen dem ersten Druck und dem zweiten Druck anzeigt, wobei der Differenzdruck mit einer Menge an Luft in dem isolierten Teil, der die Zufuhrkammer umfasst, korreliert.

13. Verfahren nach Anspruch 12, worin der isolierte Teil der Mehrstufenpumpe die Zufuhrkammer und den Filter umfasst.

14. Verfahren nach einem der Ansprüche 11 bis 13, umfassend das Durchführen einer Filteransaug-Routine durch: Ermitteln, ob ein isolierter Teil der Mehrstufenpumpe, der die Zufuhrkammer und den Filter enthält, einen negativen oder verminderten Druck erreicht hat, und Tränken des Filters in dem Prozessfluid bei dem negativen oder verminderten Druck für einen Zeitraum, um das Prozessfluid zu entgasen oder Gas oder Blasen aus dem Prozessfluid in dem isolierten Teil der Mehrstufenpumpe zu entfernen.

## Revendications

1. Système de pompage (10) comprenant une pompe à plusieurs étages (100) et un dispositif de calcul, la pompe à plusieurs étages comprenant :
une soupape d'aspiration (125) pour réguler l'entrée d'un fluide de traitement,
une partie formant l'étage d'alimentation (105) en aval de la soupape d'aspiration;
un filtre (120) en aval de la partie formant l'étage d'alimentation;
une partie formant l'étage de distribution (110) en aval du filtre, et
une soupape de refoulement (147) pour réguler la sortie du fluide de traitement ;
dans lequel la partie formant l'étage d'alimentation comprend une pompe d'étage d'alimentation (150) ; et
dans lequel la pompe d'étage d'alimentation comprend une chambre d'alimentation (155, 118), un diaphragme d'étage d'alimentation (160) qui se déplace à l'intérieur de la chambre d'alimentation et déplace le fluide de traitement dans la chambre d'alimentation, un piston (165) qui déplace le diaphragme d'étage d'alimentation, une vis-mère (170) couplée au piston, qui fait actionner le piston, et un moteur d'alimentation (175) qui entraîne la vis-mère ;
**caractérisé en ce que** la partie formant l'étage d'alimentation comprend un capteur de pression (114), dans lequel
le capteur de pression est monté sur une paroi latérale de la chambre d'alimentation pour détecter la pression de fluide dans la chambre d'alimentation ; et **en ce que**
la pompe d'étage d'alimentation est agencée pour fournir au dispositif de calcul une pression de fluide dans la chambre d'alimentation telle qu'elle est détectée par le capteur de pression et aussi **en ce que**
le dispositif de calcul est agencé pour effectuer une confirmation de filtration en :
déterminant un profil de pression de remplissage de fonctionnement basé au moins en partie sur la pression de fluide dans la chambre d'alimentation détectée par le capteur de pression ;
comparant le profil de pression de remplissage de fonctionnement avec un profil de pression de remplissage de référence ; et
déterminant s'il faut générer une alarme sur la base de la comparaison.

2. Système de pompage selon la revendication 1, dans lequel le capteur de pression est monté obliquement sur la paroi latérale de la chambre d'alimentation par rapport à la paroi latérale de la chambre d'alimentation de telle sorte qu'une partie de détection du capteur de pression est dirigée vers le haut.

3. Système de pompage selon la revendication 1 ou la revendication 2, dans lequel le dispositif de calcul est agencé pour utiliser la pression de fluide dans la chambre d'alimentation, telle qu'elle est détectée par le capteur de pression, dans un test de détection d'air, le test de détection d'air comprenant l'isolation d'une partie de la pompe à plusieurs étages qui inclut la chambre d'alimentation, la commande du moteur d'alimentation pour amener la partie isolée à une première pression, le déplacement du moteur d'alimentation sur une distance fixe, la détection d'une deuxième pression au moyen du capteur de pression, et la détermination d'une pression différentielle indiquant un changement entre la première pression et la deuxième pression, la pression différentielle correspondant à une quantité d'air dans la partie isolée qui inclut la chambre d'alimentation.

4. Système de pompage selon la revendication 3, dans lequel la partie isolée de la pompe à plusieurs étages inclut la chambre d'alimentation et le filtre.

5. Système de pompage selon l'une quelconque des revendications 1 à 4, dans lequel le dispositif de calcul est agencé pour commander la pompe à plusieurs étages dans un programme d'amorçage du filtre pour réduire la pression de fluide dans la chambre d'alimentation telle qu'elle est détectée par le capteur de pression.

6. Système de pompage selon la revendication 5, dans lequel dans le programme d'amorçage de filtre le dispositif de calcul est agencé pour déterminer si une partie isolée de la pompe à plusieurs étages qui inclut la chambre d'alimentation et le filtre a atteint une pression négative ou réduite, et pour commander la pompe à plusieurs étages pour tremper le filtre dans le fluide de traitement à la pression négative ou réduite pendant un certain temps pour dégazer ou éliminer le gaz ou les bulles du fluide de traitement dans la partie isolée de la pompe à plusieurs étages.

7. Système de pompage selon l'une quelconque des revendications 1 à 6, comprenant :
une source de fluide (15) ; et
un module de commande de pompe (20) connecté de manière communicante à la pompe à plusieurs étages via une ou plusieurs liaisons de communications (40, 45).

8. Système de pompage selon la revendication 7, dans lequel ou bien le module de commande de pompe comprend le dispositif de calcul, ou bien le module de commande de pompe est en communication avec le dispositif de calcul.

9. Système de pompage selon l'une quelconque des revendications 1 à 8, comprenant en outre :
une interface utilisateur graphique (400, 500, 600) pour afficher les profils de fonctionnement pour une pluralité de paramètres de fonctionnement de pompe surveillés par le module de commande de pompe.

10. Système de pompage selon la revendication 9, dans lequel les profils de fonctionnement incluent des informations collectées pendant un cycle de distribution incluant les segments : prêt, distribution, filtration, mise à l'atmosphère, purge, détection d'air et remplissage.

11. Procédé d'exploitation du système de pompage selon l'une quelconque des revendications 1 à 10, comprenant l'exécution d'une confirmation de filtration en :
déterminant un profil de pression de remplissage de fonctionnement basé au moins en partie sur la pression de fluide dans la chambre d'alimentation telle qu'elle est détectée par le capteur de pression ;
comparant le profil de pression de remplissage de fonctionnement avec un profil de pression de remplissage de référence ; et
déterminant s'il faut générer une alarme sur la base de la comparaison.

12. Procédé selon la revendication 11, comprenant l'exécution d'un test de détection d'air en :
isolant une partie de la pompe à plusieurs étage qui inclut la chambre d'alimentation, commandant le moteur d'alimentation pour amener la partie isolée à une première pression, déplaçant le moteur d'alimentation sur une distance fixe, détectant une deuxième pression au moyen du capteur de pression, et déterminant une pression différentielle indiquant un changement entre la première pression et la deuxième pression, dans lequel la pression différentielle correspond à une quantité d'air dans la partie isolée qui inclut la chambre d'alimentation.

13. Procédé selon la revendication 12, dans lequel la partie isolée de la pompe à plusieurs étages inclut la chambre d'alimentation et le filtre.

14. Procédé selon l'une quelconque des revendications 11 à 13, comprenant l'exécution d'un programme d'amorçage du filtre en : déterminant si une partie isolée de la pompe à plusieurs étages qui inclut la chambre d'alimentation et le filtre a atteint une pression négative ou réduite et en trempant le filtre dans le fluide de traitement à la pression négative ou réduite pendant un certain temps pour dégazer ou supprimer le gaz ou les bulles du fluide de traitement dans la partie isolée de la pompe à plusieurs étages.
